# EUROPEAN PATENT SPECIFICATION

(11) **EP 3 001 470 B1**
(45) Date of publication and mention of the grant of the patent: **06.09.2017**
(21) Application number: 14186900.8
(22) Date of filing: 29.09.2014
(51) Int. Cl.: H01L 43/00, G11C 11/16, H01L 43/10

(54) **Antiferromagnetic memory device**
Antiferromagnetische Speichervorrichtung
Dispositif de mémoire antiferromagnétique

(43) Date of publication of application: 30.03.2016
(73) Proprietor: Hitachi, Ltd., Tokyo (JP)
(72) Inventor: Wunderlich, Joerg, Cambridge, Cambridgeshire CB3 0HE (GB); Marti, Xavier, 162 53 Praha 6 (CZ); Jungwirth, Tomas, 162 53 Praha 6 (CZ)
(74) Representative: Piotrowicz, Pawel Jan Andrzej

(56) References cited:
- US-A1- 2014 169 084
- A. S. NÚÑEZ ET AL: "Theory of spin torques and giant magnetoresistance in antiferromagnetic metals", PHYSICAL REVIEW B, vol. 73, no. 21, 14 June 2006 (2006-06-14) , pages 214426/1-214426/9, XP009183308, ISSN: 0163-1829, DOI: 10.1103/PhysRevB.73.214426
- J. ZELEZNÝ ET AL: "Relativistic Néel-Order Fields Induced by Electrical Current in Antiferromagnets", PHYSICAL REVIEW LETTERS, vol. 113, no. 15, 1 October 2014 (2014-10-01), pages 157201/1-157201/5, XP055177643, ISSN: 0031-9007, DOI: 10.1103/PhysRevLett.113.157201
- A. SAKUMA ET AL: "First-principles study of the magnetic structures of ordered and disordered Mn-Ir alloys", PHYSICAL REVIEW B, vol. 67, no. 2, 1 January 2003 (2003-01-01), pages 024420/1-024420/7, XP55177447, ISSN: 0163-1829, DOI: 10.1103/PhysRevB.67.024420
- L. SZUNYOGH ET AL: "Giant magnetic anisotropy of the bulk antiferromagnets IrMn and IrMn3 from first principles", PHYSICAL REVIEW B, vol. 79, no. 2, 1 January 2009 (2009-01-01), pages 020403/1-020403/4, XP055177457, ISSN: 1098-0121, DOI: 10.1103/PhysRevB.79.020403

## Description

### Field of the Invention

The present invention relates to a memory device. In particular, the present invention relates to an antiferromagnetic memory device.

### Background

Magnetoresistive random-access memory (MRAM) is becoming increasingly used as solid-state non-volatile memory.

A typical MRAM cell includes two ferromagnetic layers separated by a thin, non-magnetic insulating layer which provides a tunnel barrier. One ferromagnetic layer, usually referred to as a "pinned layer" or "reference layer", has a magnetization whose orientation is fixed. The other ferromagnetic layer, generally referred to as the "free layer", has a magnetization whose orientation can be switched so as to be parallel or anti-parallel to the orientation of the magnetization in the pinned layer. Switching can be achieved by applying an external magnetic field or by passing a current having a sufficiently high current density in a process known as "spin torque transfer" (STT) switching. The parallel and anti-parallel states have high and low resistances respectively and, thus, can be used to store a bit of information. An overview of spin electronics, including MRAM, can be found in C. Chappert, A. Fert, and F. N. Van Dau: "The emergence of spin electronics in data storage" Nature Materials, volume 6, pages 813 to 823 (2007).

Another form of magnetoresistive device is a tunnelling anisotropy magnetoresistance (TAMR) device, as described in C. Gould et al.: "Tunneling Anisotropic Magnetoresistance: A Spin-Valve-Like Tunnel Magnetoresistance Using a Single Magnetic Layer", Physical Review Letters, volume 93, page 117203 (2004). In a TAMR device, one of the ferromagnetic layers is replaced with a non-magnetic conductive layer. Magnetoresistance arises as a result of an anisotropy in local density of states at the interface between the tunnel barrier and the ferromagnetic layer.

As described in EP 2 065 886 A1, TAMR can be increased by including a thin layer of platinum or other transition metal between the non-magnetic insulating layer and the ferromagnetic layer.

B. G. Park et al.: "A spin-valve-like magnetoresistance of an antiferromagnet-based tunnel junction", Nature Materials, volume 10, pages 347 to 351 (2011) describes another TAMR-like device having a multi-layer stack formed by a layer of nickel-iron (NiFe), a layer of iridium manganese (IrMn), a layer of magnesium oxide (MgO) and a layer of platinum (Pt). The MgO layer provides a tunnel barrier between antiferromagnetic IrMn and non-magnetic Pt. Ferromagnetic moments in the NiFe layer are reversed by an external magnetic field and the exchange-spring effect of NiFe on the IrMn layer induces rotation of the antiferromagnetic moments in IrMn layer.

The ferromagnetic NiFe layer is exchange-coupled to the antiferromagnetic IrMn layer to form an exchange spring. The ferromagnetic NiFe layer allows weak magnetic fields (i.e. of the order of the magnetic anisotropy fields in typical magnets) to rotate the antiferromagnetic moments. However, this arrangement limits the thickness of the IrMn layer to dimensions not exceeding the domain wall width in the antiferromagnet. Since the exchange spring triggers rotation of the antiferromagnetic moments at the opposite interface to the antiferromagnet /tunnel barrier interface, an antiferromagnetic TAMR effect is observable in antiferromagnetic films which are thinner than the domain wall width in the antiferromagnet.

Experiments have demonstrated that room-temperature antiferromagnetic TAMR can be realized in the exchange spring tunnel junctions in a narrow window of antiferromagnetic layer thicknesses. In such tunnel junctions, the antiferromagnetic layer should be thin enough to allow for the exchange spring rotation of antiferromagnetic moments across the entire width of the antiferromagnet, while being thick enough to avoid the suppression of the Néel temperature, T_{N}, below room temperature due to size effects.

US 2014/169084 A1 describes an antiferromagnetic memory device comprising an antiferromagnet, an insulator and an electrode arranged in a tunnel junction configuration and another antiferromagnetic memory device comprising an antiferromagnet and first and second contacts to the antiferromagnet for measuring ohmic resistance of the antiferromagnet. Both types of antiferromagnetic memory devices do not need a ferromagnet and so ferromagnets can be omitted. Nevertheless, information can be stored in the antiferromagnet. Antiferromagnetic memory devices can have advantages over ferromagnetic memory device, such as being resilient to external magnetic fields.

### Summary

According to a first aspect of the present invention there is provided an antiferromagnetic memory device. The device comprises an antiferromagnetic region having a broken inversion symmetry (that is, broken inversion symmetry in part of the unit cell corresponding to the antiferromagnetic spin sublattice or in the unit cell) along an axis and having an antiferromagnetic spin axis which is selectively orientable along first and second easy axes which are not parallel to the axis along which inversion symmetry is broken. The device comprises a conductive channel configured to define a conductive path through the antiferromagnetic region which is substantially not parallel to the axis along which inversion symmetry is broken or the device comprises a conductive path through a paramagnetic or diamagnetic region adjacent to the antiferromagnetic region (for example, above or below the antiferromagnetic region) so as to cause spin-polarised current to diffuse into the antiferromagnetic region having a component which is parallel to the axis along which inversion symmetry is broken.

Thus, when a current is passed along the conductive path, the current generates an internal field in the antiferromagnetic region such that, if the antiferromagnetic spin axis is not aligned perpendicularly to the conductive path, then it re-orientates the antiferromagnetic spin axis to be aligned perpendicularly to the conductive path. Heating of the antiferromagnetic region and/or use of ferromagnetic layers need not be used.

The conductive path is preferably arranged to be parallel or anti-parallel to the first and second easy axes. Thus, the current re-orientates the antiferromagnetic spin axis to be aligned along an easy axis.

The first and second easy axes may be substantially perpendicular to each other. The first and second easy axes may be substantially perpendicular to the axis along which inversion symmetry is broken.

The antiferromagnetic region may be a layer. The layer may have a thickness no more than 100 nm. The layer may have an areal area no more than 0.01 µm².

The antiferromagnetic material preferably exhibits cubic anisotropy.

The antiferromagnetic region may comprise an antiferromagnetic material, such as di-manganese gold (Mn₂Au), which has a bulk broken inversion symmetry in part of the unit cell corresponding to the antiferromagnetic spin sublattice or in the unit cell. The antiferromagnetic region may be configured to be sufficiently thin, for example, to have a thickness along the axis of no more than a few monolayer) so as to cause structural broken inversion symmetry.

The conductive channel may be a first conductive channel configured to define a first conductive path. The memory device may further comprise a second conductive channel configured to define a second conductive path through the antiferromagnetic region which is substantially not parallel to the axis along which inversion symmetry is broken. For example, the first and second conductive channels may be provided in a cross-shaped structure having four (or more) arms in which the antiferromagnetic region is disposed at the intersection of the arms.

The conductive channel may comprise first and second conductive arms and the antiferromagnetic region. The antiferromagnetic region may be disposed between the first and second conductive arms such that charge carrier flow between the conductive arms through the antiferromagnetic region along the path. Thus, when a bias is applied between the arms, substantially all of the current that flows from one arm flows through the antiferromagnetic region and into the other arm.

The antiferromagnetic region may have first and second opposite sides. The sides may be flat. The sides may be parallel to each other. The first and second conductive arms may be connected to the first and second opposite sides of the antiferromagnetic region respectively.

The first and second conductive arms may comprise a paramagnetic or diamagnetic material, such as gold or aluminium.

The first and second conductive arms may comprise an antiferromagnetic material. The first and second conductive arms and antiferromagnetic region may comprise the same antiferromagnetic material. The conductive arms and/or antiferromagnet may be configured such that the antiferromagnetic region exhibits weaker magnetic anisotropy than the conductive arms.

The conductive channel may comprises a paramagnetic or diamagnetic material which runs along the antiferromagnetic region such that, in response to a current running along the channel, a spin current diffuses into the antiferromagnetic region and runs through the antiferromagnetic region.

The antiferromagnetic region may lie on the conductive channel, i.e. the conductive channel may run under the antiferromagnetic region. The conductive channel may run over the antiferromagnetic region and/or to a side of the antiferromagnetic region.

The conductive channel and the antiferromagnetic region may be in direct contact. The conductive channel and the antiferromagnetic region may be separated by a tunnel barrier, for example, a thin (e.g. < 5 nm) layer of dielectric material.

The antiferromagnetic memory device may further comprise first and second contacts to the antiferromagnetic region for measuring ohmic resistance of the antiferromagnetic region. The antiferromagnetic memory device may further comprise an electrode, for example a layer of metal or semiconductor (preferably a doped semiconductor) and a dielectric layer, for example comprising magnesium oxide or silicon dioxide, and the electrode, dielectric layer and antiferromagnetic region may be arranged in a tunnel junction configuration, i.e. suitable for a tunnelling anisotropy magnetoresistance measurement.

According to a second aspect of the present invention there is provided memory. The memory comprises an array of memory cells. Each memory cell includes a memory device according to the first aspect of the present invention.

According to a third aspect of the present invention there is provided a method of operating a memory device according to the first aspect of the present invention. The method comprises driving a current along the conductive path having a sufficiently large current density that, in response to antiferromagnetic spin axis not being aligned perpendicularly to the current path, the current causes the antiferromagnetic spin axis to re-orientate perpendicularly to the current path.

The current may have a current density of at least 10⁴ Acm⁻² or at least 10⁸ Acm⁻².

Current can generate an internal field which is antiferromagnetic spin-axis independent ("field-like torque"). Alternatively, current can create an internal field which is antiferromagnetic spin-axis dependent ("anti-damping torque"). The critical current density (i.e. the current density needed for switching) tends to depend on which term dominates. The field-like torque competes only with anisotropy field, while the anti-damping torque critical current density is also governed by other micro-magnetic parameters, e.g. Gilbert damping. For Mn₂As and certain antiferromagnetic materials, the critical current density for the field-like torque tends to be relatively high, while the critical current density for the anti-damping torque is likely to be lower. By identifying which term dominates for a given antiferromagnetic material, the critical current density can be determined. Furthermore, the critical current density can be found through routine experiment, i.e. orientating the antiferromagnetic spin axis in an antiferromagnetic region along a given direction, for example, along one of the easy axes (by, for example, heating the antiferromagnetic region above a phase-changing transition temperature and applying a suitable external magnetic field and cooling the antiferromagnetic region such that the antiferromagnetic spin axis re-orientates along the given direction), applying currents of different magnitudes along the easy axis and measuring magnetoresistance and identifying which current densities do not cause switching and which current densities cause switching and so identify a minimum current density at which switching occurs.

The method may further comprise driving current along the conductive path or a conductive line proximate to the antiferromagnetic region having a current profile (for example, having steady or peak current magnitude, pulse duration and/or ramp up/ramp down rates) to heat the antiferromagnetic material to cause a transition to an ferromagnetic or paramagnetic state. The method may further comprise driving current (which may be part of the same current profile) along the conductive path or a conductive line proximate to the antiferromagnetic region to cause spin transfer torque or applying an Oersted field such that, when the current is removed, the antiferromagnetic region returns to an antiferromagnetic state and the antiferromagnetic spin axis is orientated parallel or antiparallel to the current path.

The method may further comprise measuring a resistance of the antiferromagnetic region. The method may comprise measuring resistance using an arrangement for measuring ohmic magnetoresistance. The method may comprise measuring resistance using an arrangement for measuring tunnelling anisotropy magnetoresistance.

The method may comprise passing current through the antiferromagnetic region generating heat and/or a magnetic field.

According to a fourth aspect of the present invention there is provided an antiferromagnetic memory device. The device comprises an antiferromagnetic region extending between first and second points (for example, the ends of the region or a top). The cross sectional area of the antiferromagnetic region becomes smaller as distance increases from the first point towards the second point.

Thus, in response to a current passing through the antiferromagnetic region between the first and second points, a portion of the antiferromagnetic region close to the second point may start to heat earlier and can undergo a transition from an antiferromagnetic phase to a ferromagnetic or paramagnetic phase first. This region can provide stability while some, or all, of the antiferromagnetic region undergoes a phase change and so provide better switching.

The antiferromagnetic region may comprise an antiferromagnetic material which exhibits a phase change between an antiferromagnetic and ferromagnetic phase. For example, the antiferromagnetic material may comprise iron rhodium (FeRh). The antiferromagnetic material may comprise an alloy of Mn and antimony doped with a transition metal, i.e. Mn_{2-X}A_{X}Sb can be used, where A is a transition metal such as chromium (Cr), tin (Sn), cobalt (Co) or iron (Fe), where x is greater than o and less than 1.

The antiferromagnetic region may comprise a material which exhibits a phase change between antiferromagnet and paramagnetic phases. The antiferromagnetic material may be iridium manganese (IrMn).

The antiferromagnetic region may have a broken inversion symmetry (that is, broken inversion symmetry along an axis in part of the unit cell corresponding to the antiferromagnetic spin sublattice or in the unit cell) along an axis. The antiferromagnetic region preferably has an antiferromagnetic spin axis which is selectively orientable along first and second easy axes which are not parallel to the axis along which inversion symmetry is broken.

The first and second easy axes may be substantially perpendicular to each other. The first and second easy axes may be substantially perpendicular to the axis along which inversion symmetry is broken.

### Brief Description of the Drawings

Certain embodiments of the present invention will now be described, by way of example, with reference to the accompanying drawings, in which:
Figure 1 is a perspective view of a first antiferromagnetic memory device which includes an antiferromagnetic region, which can be used to store data, and non-magnetic conductive leads;
Figure 2 is a schematic diagram of the crystal structure of an antiferromagnetic material which exhibits bulk broken inversion symmetry in part of the unit cell corresponding to the antiferromagnetic spin sublattice and which can be used in the antiferromagnetic region of the memory device shown in Figure 1;
Figure 3 shows circuitry which can be used to program the first antiferromagnetic memory device shown in Figure 1;
Figures 4a and 4b show re-orientating an antiferromagnetic spin axis in the device shown in Figure 1 using first and second currents;
Figure 5 is a perspective view of a second antiferromagnetic memory device which includes a layer stack for enabling tunnelling anisotropy magnetoresistance (TAMR) readout of an antiferromagnetic region;
Figure 6 is a perspective view of a third antiferromagnetic memory device which includes an antiferromagnetic region and antiferromagnetic leads;
Figure 7 is a perspective view of a fourth antiferromagnetic memory device which includes an antiferromagnetic region supported on a structure comprising paramagnetic or diamagnetic material;
Figure 8 illustrates diffusion of spin current into an antiferromagnetic region;
Figures 9a and 9b show re-orientating an antiferromagnetic spin axis in the device shown in Figure 8 using first and second currents;
Figure 10 is a schematic block diagram of memory including an array of memory devices;
Figure 11 is a perspective view of an antiferromagnet which can undergo a transition between an antiferromagnet phase and a ferromagnetic phase, and a heater wire running along one side of the antiferromagnet;
Figures 12a to 12h schematically illustrates transition from an antiferromagnet phase, via a ferromagnetic phase, back to an antiferromagnet phase of the antiferromagnet shown in Figure 11 using the heater wire;
Figure 13 is a perspective view of a trapezoidal prism-shaped antiferromagnet which can undergo a transition between an antiferromagnet phase and a ferromagnetic phase and a heater wire running along one side of the antiferromagnetic block;
Figures 14a to 14h schematically illustrates transition from an antiferromagnet phase, via a ferromagnetic phase, back to an antiferromagnet phase of the antiferromagnet shown in Figure 3 using Joule heating;
Figure 15 is a perspective view of a fifth antiferromagnetic memory device which includes an antiferromagnetic region and an underlying paramagnetic or diamagnetic conductive structure;
Figure 16 is shows diffusion of spin current from the underlying conductive structure into the antiferromagnetic region;
Figures 17a and 17b show re-orientating an antiferromagnetic spin axis in the device shown in Figure 15;
Figure 18 is a perspective view of a sixth antiferromagnetic memory device which includes an antiferromagnetic region and first and second conductive lines;
Figures 19a and 19b show re-orientating an antiferromagnetic spin axis in the device shown in Figure 18;
Figure 20 illustrates a first type of constriction for promoting heating in a conductive track;
Figure 21 illustrates a second type of constriction for promoting heating in a conductive track;
Figure 22 is a perspective view of a seventh antiferromagnetic memory device which includes first and second antiferromagnetic regions and first and second conductive lines;
Figure 23 illustrates first and second antiferromagnetic regions including respective antiferromagnetic spin axes and sets of easy axes; and
Figures 24a and 24b show re-orientating antiferromagnetic spin axes in the device shown in Figure 23.

### Detailed Description of Certain Embodiments

### Antiferromagnetic memory devices based on Néel spin-orbit torque writing

### First antiferromagnetic memory device 1

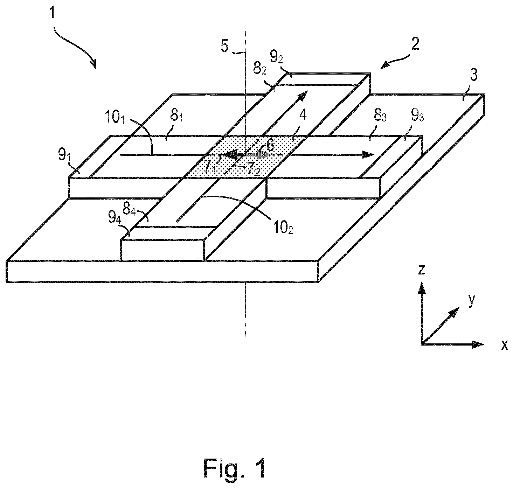

Referring to Figure 1, a first antiferromagnetic memory device 1 is shown. The device 1 generally takes the form of a flat, cross-shaped structure 2 lying on an insulating substrate 3.

The cross-shaped structure 2 includes a planar antiferromagnetic region 4 (herein also referred to simply as an "antiferromagnet") at its centre. The antiferromagnetic region 4 exhibits a broken inversion-symmetry structure along an out-of-plane axis 5. The antiferromagnetic region 4 has an antiferromagnetic spin axis 6 which is orientable along first and second in-plane, orthogonal easy axes 7₁, 7₂. The antiferromagnetic region 4 has a cuboid shape and is square in plan view. The antiferromagnetic region 4 can be rectangular in plan view or can be other shapes, e.g. cylindrical.

The antiferromagnetic region 4 comprises di-manganese gold (Mn₂Au). The antiferromagnetic region 4 may be protected by a thin (e.g. < 2nm) capping layer (not shown) of tantalum (Ta) or other suitable metal or a suitable dielectric material.

The cross-shaped structure 2 also includes first, second, third and fourth non-magnetic, conductive arms 8₁, 8₂, 8₃, 8₄ extending outwardly from the sides of the central region 4. Each conductive arm 8₁, 8₂, 8₃, 8₄ has a respective terminal 9₁, 9₂, 9₃, 9₄, for example, at its end. The conductive arms 8₁, 8₂, 8₃, 8₄ comprise a paramagnetic or diamagnetic conductive material, such as platinum or gold.

The first and third conductive arms 8₁, 8₃ define a first current path 10₁ through the antiferromagnetic region 4. The second and fourth arms 8₂, 8₄ define a second current path 10₂. The first and second current paths 10₁, 10₂ re orthogonal and are parallel to the first and second easy axes 7₁, 7₂.

Driving a current through the antiferromagnetic material in a direction which is oblique to or perpendicular to the axis 5 along which inversion symmetry is broken (in other words, in a direction which is not parallel to the axis 5) can be used to re-orientate the antiferromagnetic spin axis 6. Thus, the antiferromagnetic region 4 can be programmed without the need to heat the antiferromagnetic region 4 (thereby changing it from an antiferromagnetic phase to ferromagnetic or paramagnetic phase) or use exchange-coupled ferromagnetic elements to mediate antiferromagnetic spin axis orientation. As will also be explained in more detail hereinafter, a different structure can be used whereby driving a current in an adjacent region of paramagnetic or diamagnetic material causes a spin current to diffuse into the antiferromagnetic region. The spin current has a component which is parallel to the axis of broken symmetry and so can be used re-orientate the antiferromagnetic spin axis.

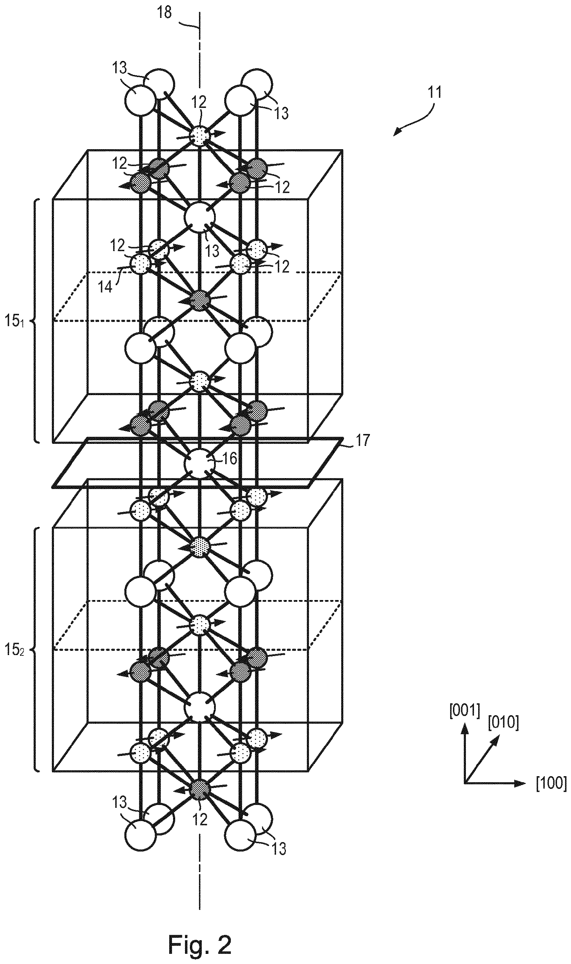

Referring to Figure 2, a unit cell 11 for Mn₂Au is shown. Mn₂Au has a body-centred tetragonal (bct) lattice structure comprising atoms of manganese 12 and gold 13. Spins 14 of the manganese atoms 12 alternate in orientation from plane to plane through the crystal, resulting in antiferromagnetic order.

Mn₂Au has two spin sublattices 15₁, 15₂ in the unit cell 11 which form inversion partners. The unit cell 11 is bulk centro-symmetric about a central gold atom 16 which lies in a centre plane 17. Inversion symmetry is broken in each spin-sublattice along the axis 18, i.e. the [001] axis, which is normal to the sublattice centre planes 15₁, 15₂. Thus, in the first antiferromagnetic device 1 shown in Figure 1, the axis 5 corresponds to [001] axis, i.e. axis 18 shown in Figure 2. A current-induced Néel spin-orbit torque arises from the fact that the lattice can be divided into the two sub-lattices 15₁, 15₂, which, individually, have broken inversion symmetry and form inversion partners.

Other antiferromagnetic materials which exhibit bulk broken inversion symmetry can be used. Alternatively, inversion symmetry can be broken along the axis 5 by making a layer of antiferromagnetic material sufficiently thin, for example a few monolayers thick, along the axis 5. Preferably, the antiferromagnetic material exhibits cubic anisotropy.

The antiferromagnetic region 4 has a length, 1, a width, w, and a thickness, t. In this case, the length and width are equal, although they need not be. The length, 1, and width, w, may be no more than 200 nm or no more than 100 nm. The thickness, t, is preferably no more than 20 nm, more preferably no more than 10 nm and still more preferably not more than 5 nm.

The first antiferromagnetic memory device 1 may be fabricated by a depositing (for example, by sputtering) a layer (not shown) of paramagnetic or diamagnetic conductive material and patterning the deposited layer (not shown) using election-beam or photolithography to form a mask (not shown) and dry etching unwanted regions of the deposited layer to form the conductive arms 8₁, 8₂, 8₃, 8₄ and then depositing (for example by sputtering) a layer (not shown) of the antiferromagnetic material and patterning the layer in a similar way to form the central antiferromagnetic region 4.

Without wishing to be bound by theory, it is thought the current generates non-equilibrium Néel-order staggered fields which are opposite on the two spin sublattices 15₁, 15₂ (Figure 2) in the antiferromagnetic region 4.

Antiferromagnetic spin-axis reorientation due to current-induced Néel spin-orbit torque is not thought to be limited by ultra-fast antiferromagnetic spin dynamics itself, but by any circuitry time-scales for delivering electrical pulses, which can be of order about 100 ps.

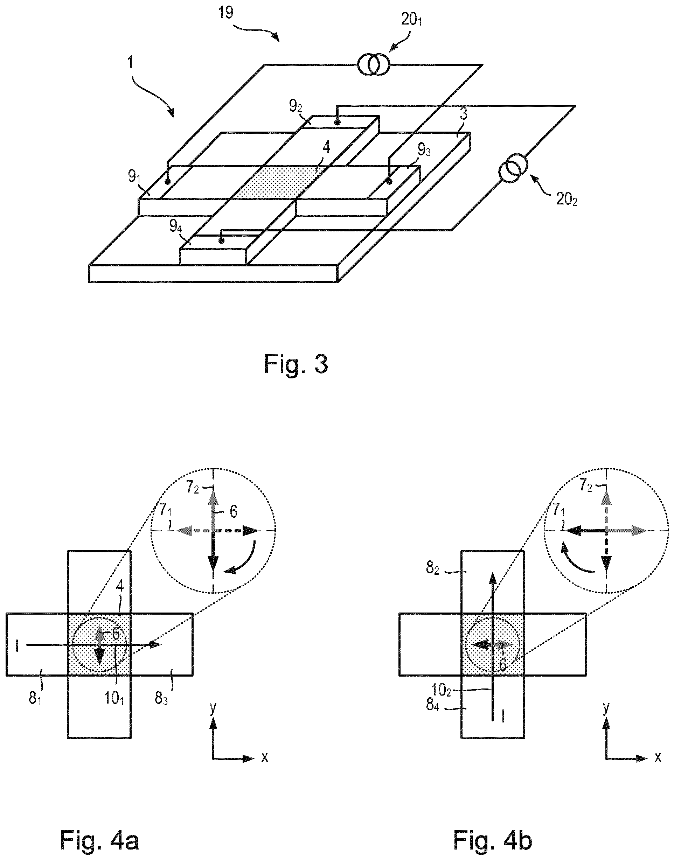

Referring to Figure 3, a circuit 19 used for selectively driving currents through the first or second current paths 10₁, 10₂ comprises first and second current sources 20₁, 20₂ coupled to the first and third terminals 9₁, 9₃ and to the second and fourth terminals 9₂, 9₄ respectively.

If the current along the path 10₁, 10₂ has a sufficiently high current density (for example, in the case of Mn₂Au, a sufficiently high current density is 10⁸ to 10⁹ Acm⁻²), a spin-orbit torque can be used to re-orientate the antiferromagnetic spin axis 6 in the antiferromagnetic region 4.

Referring to Figure 4a, if a sufficiently large current, I, is driven from the first conductive arm 8₁, through the antiferromagnetic region 4, to the third conductive arm 8₃ or *vice versa,* then, if the antiferromagnetic spin axis 6 is orientated along the first easy axis 7₁, then it is re-orientated so that it lies along the second easy axis 7₂.

Referring to Figure 4b, if a sufficiently large current, I, is driven from the fourth conductive arm 8₄, through the antiferromagnetic region 4, to the second conductive arm 8₂ or *vice versa,* then, if the antiferromagnetic spin axis 6 is orientated along the second easy axis 7₂, then it is re-orientated so that it lies along the first easy axis 7₃.

The state of the device can be read by measuring ohmic anisotropy magneto-resistance (AMR), for example, as described in US 2014/169084 A1. The magneto-resistance can be measured, for example, by applying a voltage, V, between the first and third conductive arms 8₁, 8₃ and measuring the current, I.

The state of the device can be read by measuring the tunnelling anisotropy magneto-resistance (TAMR).

### Second antiferromagnetic memory device 21

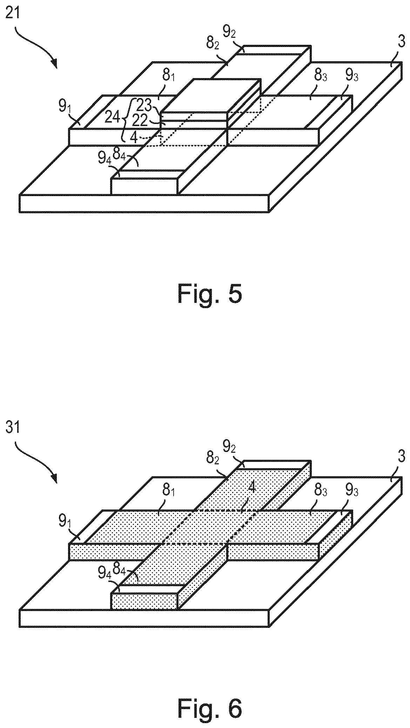

Referring to Figure 5, a second antiferromagnetic memory device 21 is shown. The second antiferromagnetic memory device 21 is the same as the first antiferromagnetic memory device 1 (Figure 1) except that the second antiferromagnetic memory device 21 also includes a layer 22 of dielectric material on the antiferromagnetic region 4 and a layer 23 of conductive material on the dielectric layer 22 thereby forming a layer stack 24.

The dielectric layer 22 comprises crystalline magnesium oxide (MgO) and is sufficiently thin (for example, 2.5 nm) to form a tunnel barrier. Other dielectric materials such as silicon dioxide (SiO₂), aluminium oxide (Al₂O₃) or high-k dielectrics such as hafnium oxide (HfO₂) can be used. The dielectric material may be antiferromagnetic.

The antiferromagnetic layer 4 is in direct contact with the dielectric layer 22. Thus, a protective capping layer can be omitted.

The conductive layer 23 may comprise tantalum (Ta). However, other metals or a semiconductor material can be used. Further details regarding TAMR effect and readout can be found in US 2014/169084 A1 *ibid.*

Referring again to Figure 1, in the first antiferromagnetic memory device 1, the cross-shaped structure 2 is formed from different materials. However, the cross-shaped structure can be formed from the same material, i.e. a single layer of antiferromagnetic material.

### Third antiferromagnetic memory device 31

Referring to Figure 6, a third antiferromagnetic memory device 31 is shown. The third is the same as the first antiferromagnetic memory device 1 (Figure 1) except that conductive arms 8₁, 8₂, 8₃, 8₄ are also formed from an antiferromagnetic material, for example, the same antiferromagnetic material used to form the antiferromagnetic region 4. Thus, a single deposition step and a single patterning step can be used. The antiferromagnetic region 4 can be modified to reduce its magnetic anisotropy, for example, by implanting helium ions (not shown) or by thinning the region 4, and so facilitate switching at a lower current before the antiferromagnetic conductive arms 8₁, 8₂, 8₃, 8₄.

The third antiferromagnetic memory device 31 may be modified by omitting the capping layer (not shown) and providing a tunnel barrier layer (not shown) in direct contact with the antiferromagnetic region 4 and an electrode layer (not shown) on the tunnel barrier layer (not shown) so as to allow TAMR-based readout in the same way as the second memory device 21 (Figure 5).

Referring again to Figure 1, in the first antiferromagnetic device 1, current is driven from one conductive arm 8₁, through the antiferromagnetic region 4, to another one conductive arm 8₃ within the same plane. However, a different arrangement can be used.

### Fourth antiferromagnetic memory device 41

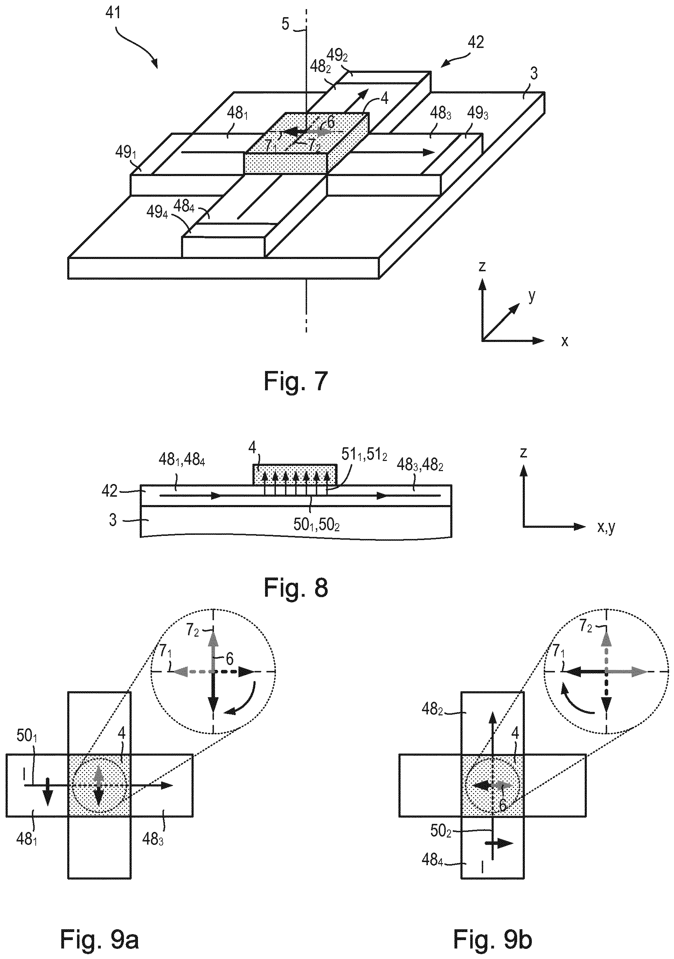

Referring to Figure 7, a fourth antiferromagnetic memory device 41 is shown. The fourth memory device 41 is similar to the first memory device 1 (Figure 1) except that spin current is diffused into the antiferromagnetic region 4 from an underlying cross-shaped structure 42 comprising a paramagnetic or diamagnetic conductive material, such as platinum, tantalum or tungsten.

The cross-shaped structure 42 includes first, second, third and fourth arms 48₁, 48₂, 48₃, 48₄. Each conductive arm 48₁, 48₂, 48₃, 48₄ has a respective terminal 49₁, 49₂, 49₃, 49₄ at its end.

The first and third conductive arms 48₁, 48₃ define a first current path 50₁ through the underlying cross-shaped structure 42. The second and fourth arms 48₂, 48₄ define a second current path 50₂. The first and second current paths 50₁, 50₂ are orthogonal and are parallel to the first and second easy axes 71, 72.

Referring also to Figure 8, the underlying structure 42 is a source of spin-polarized current 51₁, 51₂ (also referred to herein as a "spin current"). When a current flows through the paramagnetic or diamagnetic material, along a current path 50₁, 50₂, a transverse spin current is generated due to the spin Hall effect. In other words, spin angular momentum flows, without flow of electrical charge, in a direction perpendicular to the applied electrical current. This is because if spin-up electrons are deflected in, for example, a positive transverse direction, then spin-down electrons are deflected in the opposite direction, i.e. a negative transverse direction. Since there is the same number of spin-up and spin-down electrons in a non-magnetic system (such as a paramagnet or diamagnet), there is no net charge flow in the transverse direction, but there is a net spin-current. In a bilayer geometry, the in-plane electrical current in the paramagnet (or diamagnet) generates an out-of-plane pure spin current due to the spin Hall effect. This out-of-plane spin current is absorbed in the antiferromagnet at the antiferromagnet-paramagnet (or diamagnet) interface, which causes a torque on the moments in the antiferromagnet.

Along the interface between the underlying structure 42 in which the spin current flows and the antiferromagnetic region 4, spin current 51₁, 51₂ diffuses into the antiferromagnetic region 4. The spin current 51₁, 51₂ diffuses in a direction which is perpendicular to the interface, i.e. in a direction along the axis 5.

In conventional magnetic tunnel junctions with two ferromagnetic layers, a spin current can be injected from one ferromagnetic layer magnet serving as a "spin source" to the other ferromagnetic layer acting as a "spin drain". In a conventional magnetic tunnel junction, spin current should have a component perpendicular to the planes of the two ferromagnetic layers so that the spin current can propagate from the source to the drain. In conventional magnetic tunnel junctions, the easiest way to achieve this is to drive an electrical current from the source to the drain in the vertical direction (perpendicular to the layer planes). In a spin Hall effect geometry, it is a lateral current in the paramagnet which can serve as a spin source and which can generate a vertical spin current in the paramagnet which can then enter a layer acting as a spin drain. In the fourth antiferromagnetic memory device 41, the antiferromagnetic region 4 can effectively serve as the spin drain.

Referring to Figure 9a, if a sufficiently large current, I, is driven from the first conductive arm 48₁ to the third conductive arm 48₃ or *vice versa,* then, if the antiferromagnetic spin axis 6 is orientated along the first easy axis 71, then it is re-orientated so that it lies along the second easy axis 72.

Referring to Figure 4b, if a sufficiently large current, I, is driven from the fourth conductive arm 48₄, through the antiferromagnetic region 4, to the second conductive arm 48₂ or *vice versa,* then, if the antiferromagnetic spin axis 6 is orientated along the second easy axis 7₂, then it is re-orientated so that it lies along the first easy axis 7₁.

### Non-volatile memory

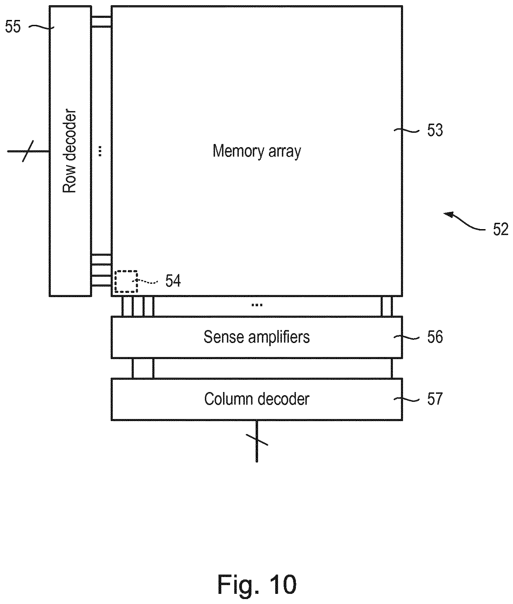

Referring to Figure 10, a non-volatile memory 52 is shown. The memory 52 includes an array 53 of cells 54, a row decoder 55, sense amplifiers 56 and a column decoder 57.

Each cell 54 may be based on an antiferromagnetic memory device 1, 21, 31, 41 hereinbefore described or an antiferromagnetic memory device 81, 101, 111 hereinafter described.

### Antiferromagnetic memory devices using heat-assisted writing

As explained earlier, the antiferromagnetic spin axis of an antiferromagnetic region which is formed from a suitable antiferromagnetic material and/or which is suitably configured (e.g. by making it sufficiently thin) can be switched using a current-induced Néel spin-orbit torque. Thus, there is no need to heat the antiferromagnetic region. However, heat-assisting writing can also be used in some antiferromagnetic memory device which uses a current-induced Néel spin-orbit torque for writing.

For example, the antiferromagnetic spin axis can be orientated along one easy axis using Néel spin-orbit torque and can be orientated along another easy axis using hear-assisted writing. In particular, the antiferromagnetic spin axis can be orientated along the other easy axis by heating the device so that the antiferromagnetic material becomes ferromagnetic or paramagnetic, using an Oersted field to orientate magnetic moments in the ferromagnetic or paramagnetic phase in a direction such that when the antiferromagnetic region cools and become antiferromagnetic, the magnetic moments re-orientate so as to be parallel or antiparallel to the other easy axis (i.e. the antiferromagnetic spin axis becomes orientated along the other easy axis).

### Phase transitions in an antiferromagnet

Iron rhodium (FeRh) and some other antiferromagnetic materials exhibit a transition between antiferromagnet and ferromagnetic phases. Reference is made to S. O. Mariager et al.: "Imaging the antiferromagnetic to ferromagnetic first order phase transition of FeRh", arXiv:1301.4164v1 [cond-mat.mtrl-sci] 17 Jan 2013.

This property can be exploited in an antiferromagnetic memory device by non-uniformly heating an antiferromagnetic region so that a low-temperature antiferromagnetic phase and a high-temperature ferromagnetic or paramagnetic phase concurrently exist in the storage element separated by a phase boundary. Magnetic moments in the high-temperature ferromagnetic or paramagnetic phase can be orientated using an applied magnetic field. This magnetic field may be generated using a conductive line which is also used to heat the antiferromagnetic region.

Magnetic moments in the ferromagnetic or paramagnetic phase are coupled to magnetic moments in the antiferromagnetic phase by an exchange field. In the antiferromagnetic phase, the exchange field can be much stronger than the applied magnetic field. Thus, the ferromagnetic phase can help to stabilise the antiferromagnetic phase. Furthermore, the transition temperature is field dependent and so the transient high-temperature ferromagnetic phase can assist transition of the antiferromagnet phase to the ferromagnetic phase.

Before describing in detail embodiments of memory devices which exploit a transient high-temperature ferromagnetic phase, simpler antiferromagnetic devices and methods of non-uniform heating will first be described.

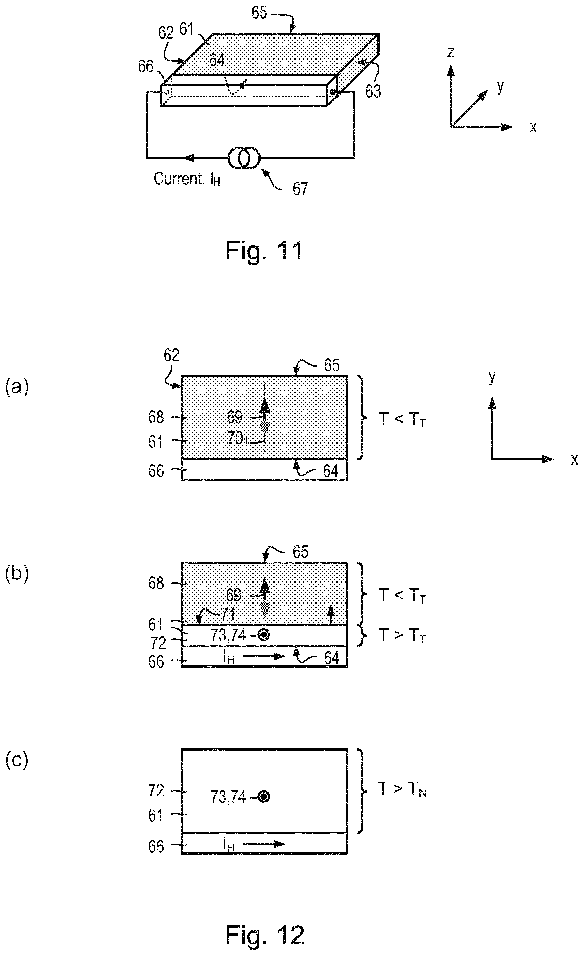

Figure 11 is a perspective view of a generally planar antiferromagnet 61 which extends from a first end 62 to a second end 63 between first and second sides 64, 65. An elongate heater wire 66 is placed in thermal contact with the antiferromagnet 61 running along one side 64 of the antiferromagnet 61. The antiferromagnet 61 and heater wire 66 may be electrically isolated from each other using a region of dielectric material (not shown). A current source 67 is arranged to drive current through the heater wire 66.

The antiferromagnet 61 is formed from FeRh or some other antiferromagnetic material which exhibits a transition between antiferromagnet and ferromagnetic phases and the wire 66 comprises, for example, tungsten (W) or other material having a suitable resistivity, p. The wire 66 has dimensions for a given resistivity, p, and current, I_{H}, to generate sufficient heat energy to heat the antiferromagnet 61 to a temperature, T, above the antiferromagnet-ferromagnetic phase transition temperature, T_{T}, for the antiferromagnet.

The antiferromagnet 61 and wire 66 may be formed by sputtering material on a substrate (not shown) using e-beam lithography and lift-off to pattern the antiferromagnet 61 and wire 66. The antiferromagnet 61 may be monocrystalline or polycrystalline.

Referring to Figure 12a, the antiferromagnet 61 has an initial temperature which lies below the transition temperature, T_{T}, of the antiferromagnet 61. For FeRh, the transition temperature, T_{T}, is about 105 °C and so the initial temperature, T₁, may be room temperature. The antiferromagnet 1 contains an antiferromagnetic phase 68 having magnet moments 69 which are orientated along a first magnetic easy axis 70₁.

A current, I_{H}, is driven through the heater wire 66 which generates heat and increases the temperature of the antiferromagnet 1 adjacent.

Referring to Figure 12b, a phase boundary 71 between the antiferromagnetic phase 68 and a ferromagnetic phase 72 propagates through the antiferromagnet 61 away from the wire 66. Behind the phase boundary 71, the antiferromagnet 61 has a temperature above the transition temperature, T_{T}, and is ferromagnetic. In the ferromagnetic phase 72, magnetic moments 73 are aligned with the Oersted field 74 generated by the wire 76.

In Figure 12b, for a current, I_{H}, flowing along the x-axis, the magnetic field 74 in the antiferromagnet 61 is directed along the z-axis (i.e. out of the page).

Referring to Figure 12c, the phase boundary 71 may continue to propagate until the whole antiferromagnet 61 has changed into a ferromagnetic state 72.

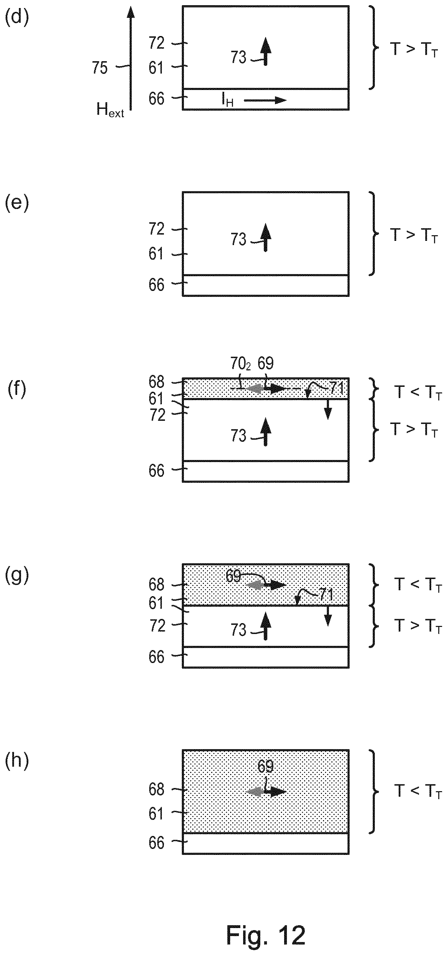

Referring to Figure 12d, an external magnetic field 75 may applied to the antiferromagnet 61. As shown in Figure 12d, if a sufficiently strong field is applied, magnetic moments 73 in the ferromagnetic phase 72 may be realigned, for example, along the y-axis.

Referring to Figure 12e, if the current, I_{H}, is switched off, then the antiferromagnet 61 begins to cool. The external magnetic field 75 is removed and magnetization 73 may be maintained.

Referring to Figure 12f, if the antiferromagnet 61 cools sufficiently, then the antiferromagnetic phase 66 reforms. The magnetic moments 69 in the antiferromagnetic phase 68 are coupled via exchange field to the magnetic moments 73 in the ferromagnetic phase 72. The magnet moments 69 in the antiferromagnetic phase 68 are orientated along a second magnetic easy axis 70₂. Preferably, the first and second easy axes 70₁, 70₂ are orthogonal (i.e. arranged at right angles).

Referring to Figure 12g, the phase boundary 71 recedes until the whole of the antiferromagnet 61 returns to the antiferromagnetic phase 68, as shown in Figure 12h.

A separate external magnetic field 75 need not be applied. By placing the wire 66, for example, below or above the antiferromagnet 61, the heater wire 66 may generate not only heat for increasing the temperature of the ferromagnet, but also an in-plane magnetic field.

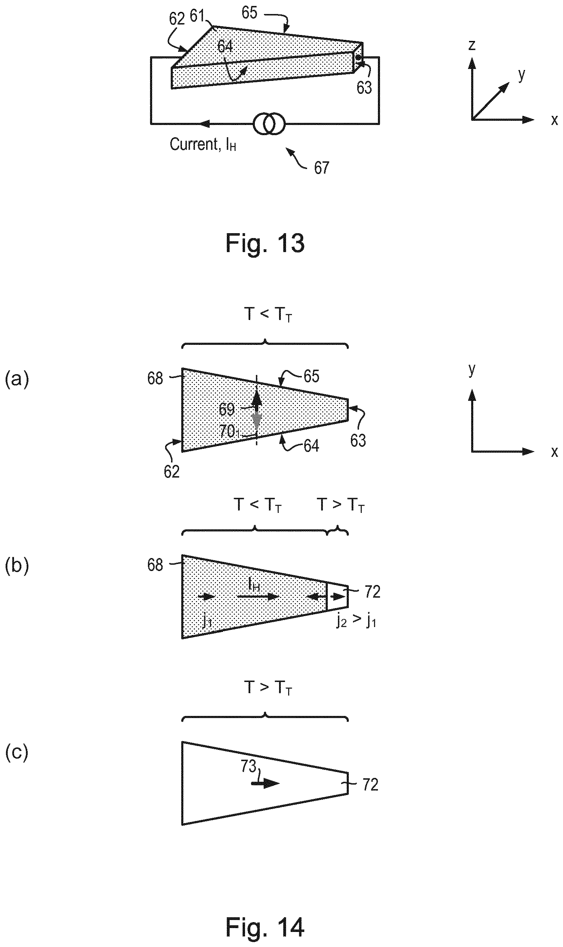

Figure 13 is a perspective view of another generally planar antiferromagnet 61 which extends from a first end 62 to a second end 63. However, the width of the antiferromagnet 61 between first and second sides 64, 65 may vary, e.g. by tapering. Additionally or alternatively, the thickness of the antiferromagnet 61' may vary. In this arrangement, the heater wire is omitted. Instead, the current source 67 is connected between the ends 64, 65 of the antiferromagnet.

The antiferromagnet 61 has dimensions for a given resistivity, p, and current, I_{H}, to generate sufficient heat energy to heat itself to a temperature, T, above the antiferromagnet-ferromagnetic phase transition temperature, T_{T}, for the antiferromagnet.

Referring to Figure 14a, the antiferromagnet 61 has an initial temperature which lies below the transition temperature, T_{T}, of the antiferromagnet 61. The antiferromagnet 61 contains an antiferromagnetic phase 68 having magnet moments 69 which are orientated along a first magnetic easy axis 70₁.

A current, I_{H}, is driven through the antiferromagnet 61.

Referring to Figure 14b, the transverse cross-sectional area, A, of the antiferromagnet 61 varies along its length and so the current density, j, varies inversely proportionally to area, A. The current density, j₁, proximate to the first end 62 of the antiferromagnet 61 is smaller than the current density, j₂, close to the second end 63 of the block of antiferromagnetic material. Consequently, the temperature T at the second end 63 of the antiferromagnet 61 may rise at a quicker rate than at the first end 62. A phase boundary 71 starts to propagate from the second end 63 towards the first end 62 as a ferromagnetic phase 72 forms.

In Figure 14b, for a current, I_{H}, flowing along the x-axis, the magnetic field 74 in the antiferromagnet 61 is directed along the z-axis (i.e. out of the page).

Referring to Figure 14c, the phase boundary 71 may continue to propagate until the whole antiferromagnet 61 becomes ferromagnetic.

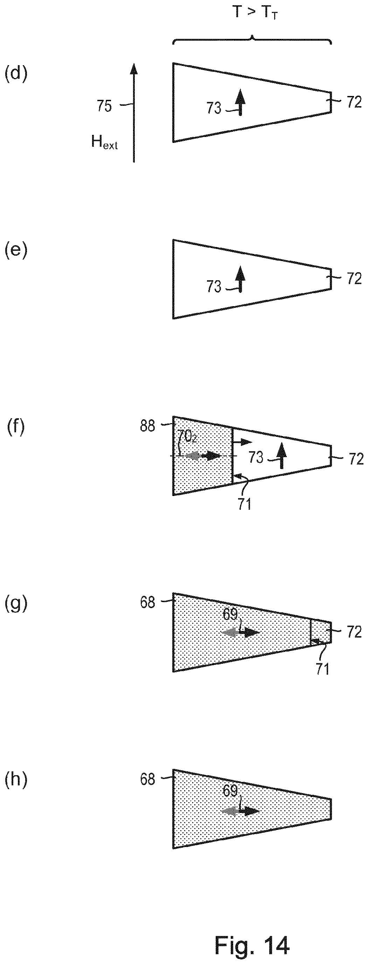

Referring to Figure 14d, an external magnetic field 75 may applied to the antiferromagnet 61. As shown in Figure 14d, if a sufficiently strong field is applied, magnetic moments 73 in the ferromagnetic phase 72 may be realigned, for example, along the y-axis.

Referring to Figure 14e, if the current, I_{H}, is switched off, then the antiferromagnet 61 begins to cool. The external magnetic field 75 is removed and magnetization 73 may be maintained.

Referring to Figure 14f, if the antiferromagnet 61 cools sufficiently, then the antiferromagnetic phase 66 re-forms. The magnetic moments 69 in the antiferromagnetic phase 68 are coupled via exchange field to the magnetic moments 73 in the ferromagnetic phase 72. The magnet moments 69 in the antiferromagnetic phase 68 are orientated along a second magnetic easy axis 70₂.

Referring to Figure 14g, the phase boundary 71 recedes until the whole of the antiferromagnet 61 returns to the antiferromagnetic phase 68, as shown in Figure 14h.

### Fifth antiferromagnetic memory device 81

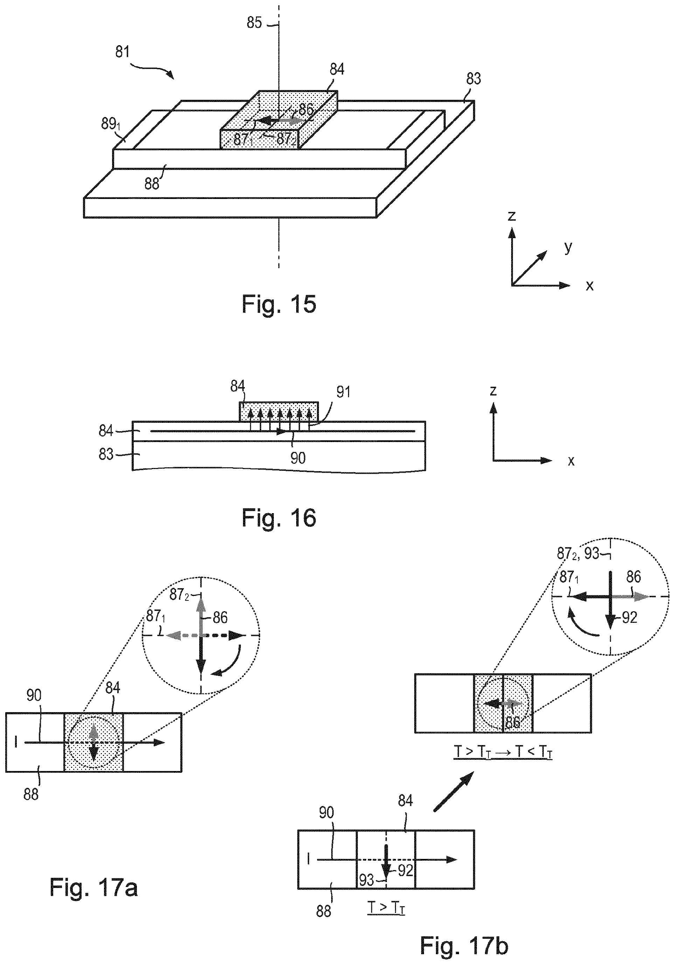

Referring to Figure 15, a fifth antiferromagnetic memory device 81 is shown. The device 81 generally takes the form of a flat, elongated structure 82 lying on an insulating substrate 83.

The structure 82 includes a planar antiferromagnetic region 84. The antiferromagnetic region 84 exhibits broken inversion symmetry along an out-of-plane axis 85. The antiferromagnetic region 84 has an antiferromagnetic spin axis 86 which is orientable along first and second in-plane, orthogonal easy axes 87₁, 87₂.

The antiferromagnetic region 84 comprises di-manganese gold (Mn₂Au). The antiferromagnetic region 4 may be protected by a thin (e.g. < 2nm) capping layer (not shown) of tantalum (Ta) or other suitable metal or a suitable dielectric material.

The antiferromagnetic region 84 is supported on a conductive strip 88 having first and second terminals 89₁, 89₂ between the terminals 89₁, 89₂. The conductive strip 88 comprises a paramagnetic or diamagnetic conductive material, such as platinum or gold.

The conductive strip 88 defines a current path 90 through the antiferromagnetic region 84. The current path 90 I is parallel to the first easy axis 87₁.

Referring also to Figure 16, the conductive strip 88 is a source of spin-polarized current 91 due to the spin Hall effect in the same way as in fourth antiferromagnetic memory device 41 (Figure 7). Along the interface between the underlying conductive strip 82 and the antiferromagnetic region 84, spin current 91 diffuses into the antiferromagnetic region 84. The spin current 91 diffuses in a direction which is perpendicular to the interface, i.e. in a direction along the axis 5.

A circuit (not shown) used for driving a current through the conductive strip 82 comprises a current source (not shown) coupled to the terminals 89₁, 89₂.

Referring to Figure 17a, the antiferromagnetic spin axis 86 can be switched from the first to the second easy axis 87₁, 87₂ using Neel spin-orbit torque in the manner hereinbefore described. This can occur using a current, I, which is at least equal to a threshold current, I_{NSOT}, for current-induced torque-based switching but not so high so such that the temperature, T, of the antiferromagnetic region 84 stays below the phase-change temperature, T_{T}, of the antiferromagnetic region 84, i.e. the temperature at which antiferromagnetic region 84 changes from being antiferromagnetic to being paramagnetic or ferromagnetic.

Referring to Figure 17b, the antiferromagnetic spin axis 86 can be switched from the second easy axis 87₂ to the first easy axis 87₁ by passing a sufficiently high current, I, which exceeds a threshold, I_{HIGH}, to cause the temperature of the antiferromagnetic region 4 to exceed the phase-change temperature, T_{T}. The current also exceeds a threshold current, I_{STT}, which applies a spin-transfer torque to the magnetic moments 92, for example in a ferromagnetic phase, and causes them to rotate so that they lie along an axis 93 which is perpendicular to the current. The current is switched off which results in the antiferromagnetic region 84 cooling below the phase-change temperature, T_{T}. As they return antiferromagnetic ordering, the magnetic moments 92 rotate through 90 degrees such that the antiferromagnetic spin axis 86 is perpendicular to the original axis 93.

Steady or quasi-steady state currents need not be used. Current having a time-varying waveform (which may include pulses) can be used. For example, short, high-magnitude current pulses can be used to discourage heating, while achieving sufficiently high currents for spin-orbit torque switching. Conversely, longer pulses having a magnitude which do not exceed the threshold current value for spin-orbit torque switching can be used for rapid heating.

The fifth antiferromagnetic memory device 81 may include a pair of contacts (not shown) for measuring ohmic AMR or a tunnel barrier arrangement for measuring tunnelling AMR as described in US 2014/169084 A1 *ibid*.

Although one conductive line can be used for heating and generating an Oersted field, two crossed lines can provide further degrees of control over heating, allow Oersted fields having different orientations (e.g. perpendicular) to be applied and/or provide a readout arrangement, such as a tunnel barrier arrangement.

### Sixth antiferromagnetic memory device 101

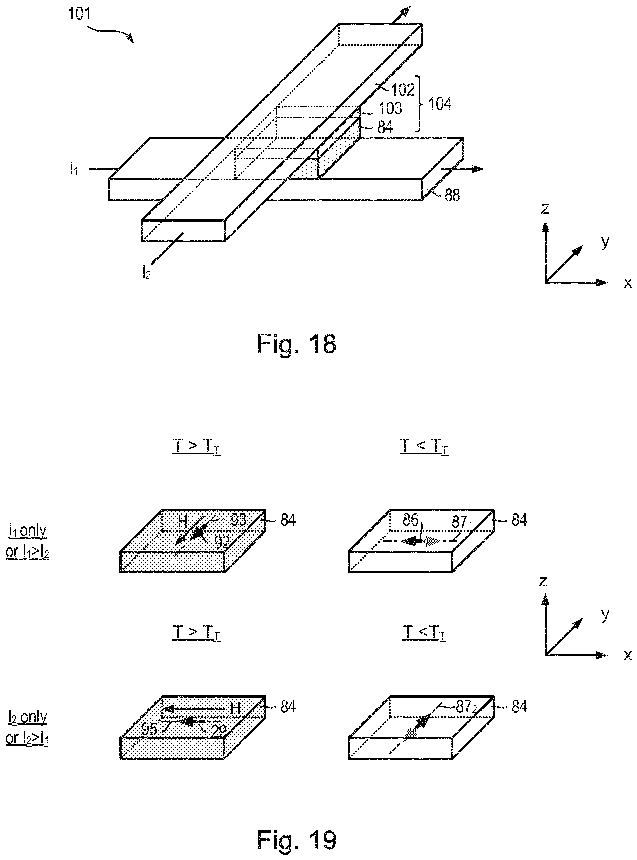

Referring to Figure 18, a sixth antiferromagnetic memory device 101 is shown. The device 101 is similar to the fifth device 81 except that it includes a second conductive line 102, a thin (e.g. < 5 nm) dielectric layer 103, such as silicon dioxide (SiO₂) or magnesium oxide (MgO), disposed between the antiferromagnetic layer 84 and the second conductive line 102 to form a tunnel barrier configuration 103. The substrate 83 (Figure 16) is omitted from Figure 18 for clarity.

Referring to Figure 19, the first and second conductive lines 88, 102 may be used to heat the antiferromagnetic layer 84 and provide orthogonal magnetic fields, H.

### Promoting heat generation by conductive lines

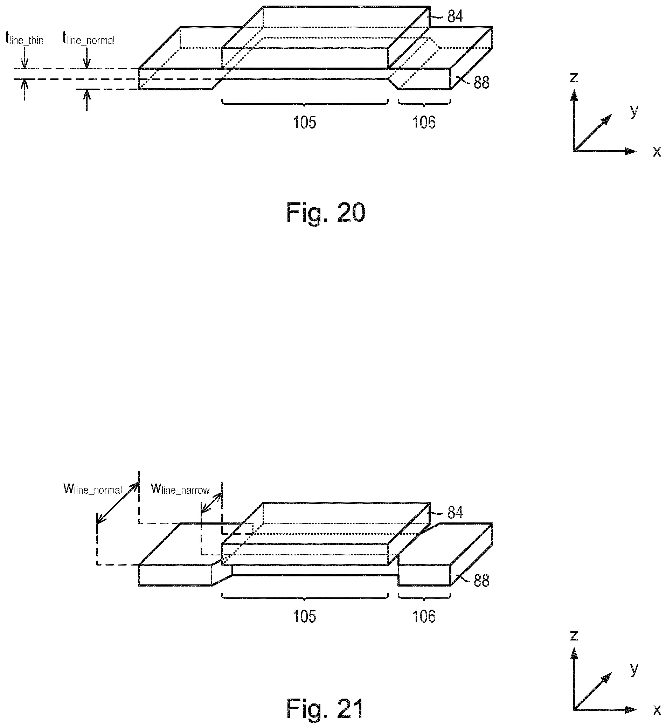

The conductive line 88 (or conductive lines 88, 102) can be configured to promote heating and Figures 20 and 21 illustrate two ways of adapting the conductive lines 88. It will be appreciated that if a second conductive 102 line is provided, then it can be adapted in a corresponding way to the other conductive line 88.

Referring to Figure 20, a section (or "length") 105 of a conductive line 88 which is next to the antiferromagnetic region 84 may be thinner than another section 106 of the line 88. Thus, the transverse cross-sectional area of a conductive line 88 is reduced and so the section 105 has a higher resistance per unit length than the other section 106 of the line 88.

Referring to Figure 21, additionally or alternatively, the section 105 may be narrower than another section 106 of the line 88.

### Seventh antiferromagnetic memory device 111

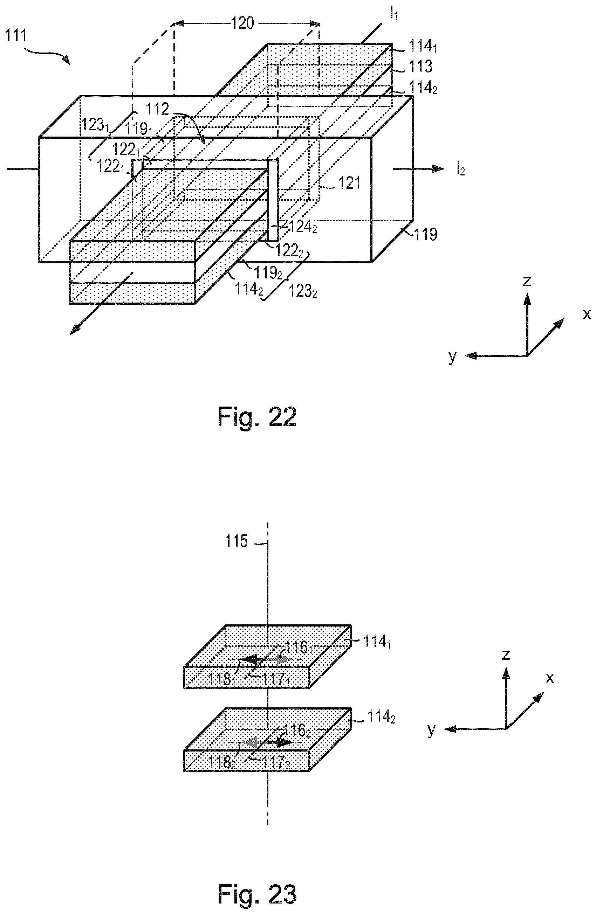

Referring to Figure 23, a seventh antiferromagnetic memory device 111 is shown. The seventh antiferromagnetic memory device 111 is similar to the fifth antiferromagnetic memory device 81 (Figure 15) in that a first state can be written using Néel spin-orbit torque and a second state can be written using heat-assisted phase transition and the application of an Oersted field.

The seventh antiferromagnetic device 111 includes a stacked layer structure 112.

The stacked layer structure 112 includes a first conductive line 113 and first and second planar antiferromagnetic regions 114₁, 114₂ (herein after referred to as upper and lower planar antiferromagnetic regions 114₁, 114₂) sandwiching the first conductive line 113. Each antiferromagnetic region 114₁, 114₂ generally extends along the first and second directions, i.e. lies in the x-y plane, and are spaced apart along the third direction (z-axis). The first conductive line 113 extends along the first direction (i.e. along x-axis). The first conductive line 113 has first and second terminals (not shown) at opposite ends of the line for driving current through the line 113. The first conductive line 113 comprises a paramagnetic or diamagnetic conductive material, such as platinum or gold. In a similar way to the conductive line 88 (Figure 15) in the fifth antiferromagnetic memory device 81 (Figure 15), the first conductive line 113 is used to diffuse spin current into the antiferromagnetic regions 114₁, 114₂ for Néel spin-orbit torque switching.

The antiferromagnetic regions 114₁, 114₂ are in the form of elongate lines, i.e. where length, 1, is much greater than width, w (for example w ≥ 0.1l). However, the antiferromagnetic regions 114₁, 114₂ need not take the form of elongate lines and may be, for example, near-square or square, where length, 1, is approximately equal to width, w (for example, 2l ≥ w ≥ 0.5l).

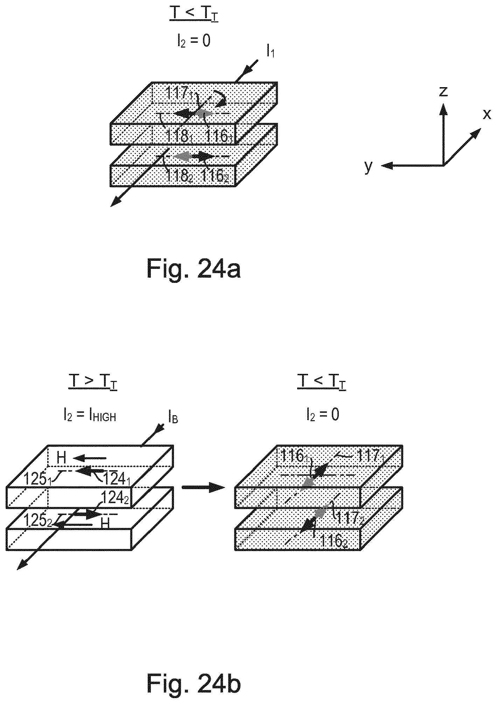

Referring also to Figure 24, each antiferromagnetic region 114₁, 114₂ exhibits broken inversion symmetry along an out-of-plane axis 115. The antiferromagnetic region 114₁, 114₂ each have a respective antiferromagnetic spin axis 116₁, 116₂ which is orientable along first and second in-plane, orthogonal easy axes 117₁, 117₂, 118₁, 118₂.

Referring in particular to Figure 23, the antiferromagnetic memory device 111 also includes a second conductive line 119 which is used for heating and for read out. The first and second conductive lines 113, 119 cross, preferably at right angles.

The second conductive line 119 includes a section 120 in which the line 119 splits into first and second portions 119₁, 119₂ (hereinafter referred to as the upper and lower portions 119₁, 119₂) which define a transverse passage 121. The upper portion 119₁ runs over the top of the upper antiferromagnetic region 114₁ and the lower portion 119₂ runs under the lower antiferromagnetic region 114₂. Thus, the upper and lower first conductive portions 119₁, 119₂ sandwich the upper and lower antiferromagnetic regions 114₁, 114₂.

A thin layer 122₁ of dielectric material is interposed between the upper antiferromagnetic region 114₁ and the upper portion 119₁ of the second conductive line 119 thereby forming a tunnel barrier arrangement 123₁. Similarly, a thin layer 122₂ of dielectric material is interposed between the lower antiferromagnetic region 114₂ and the lower portion 119₂ of the second conductive line 119 thereby forming a second tunnel barrier arrangement 123₂.

First and second spacer-like layers 124₁, 124₂ of dielectric material, for example, silicon dioxide (SiO₂) or magnesium oxide (MgO), run down the sides of the stack layer structure 112, between the stack layer structure 112 and the side walls of the conductive line 119 so as to avoid electrical shorts.

The upper dielectric layer 122₁ and the side dielectric layers 124₁, 124₂ may be provided by the same layer of dielectric material. For example, a lower half of the second conductive line 119 and then the stacked layer structure 112 may be formed before a conformal layer of dielectric material is deposited over the stacked layer structure 112 (for instance, by sputtering). After suitable patterning of the dielectric layer (i.e. to remove unwanted regions of material), the second half of the second conductive line 119 can then be formed over the dielectric layer.

Referring to Figure 25a, the antiferromagnetic spin axes 116₁, 116₂ can be switched from the first easy axis 117₁, 117₂ to the second easy axis 118₁, 118₂ using Neel spin-orbit torque in the manner hereinbefore described.

Referring to Figure 25b, the antiferromagnetic spin axes 116₁, 116₂ can be switched from the second easy axis 118₁, 118₂ to the first easy axis 117₁, 117₂ by passing a sufficiently high current, I, which exceeds a threshold, I_{HIGH}, through the second conductive line 119 to cause the temperature of the antiferromagnetic regions 114₁, 114₂ to exceed the phase-change temperature, T_{T}.

A current, I_{B}, is passed through the first conductive line 113 which orientates magnetic moments 124₁, 124₂ in the regions 114₁, 114₂ which are ferromagnetic (or paramagnetic) along axis 125. The orientation of the moments 124₁ in the first region 114₁ are antiparallel to the moments 124₂ in the second region 114₂.

The heating current is switched off which results in the antiferromagnetic regions 114₁, 114₂ cooling below the phase-change temperature, T_{T}. As they return antiferromagnetic ordering, the magnetic moments 124₁, 124₂ flip through 90 degrees such that the antiferromagnetic spin axes 116₁, 116₂ are perpendicular to the original axis 125.

As explained earlier, with reference to Figures 20 and 21, the geometry and dimensions of the second conductive line 119 may be adapted so as to promote heating.

The antiferromagnetic memory device 111 can be read out by measuring tunnelling AMR between the first and second conductive lines 113, 119.

The antiferromagnetic devices herein described may be fabricated using fabrication techniques, such as deposition, lithography and etching. Layer may be deposited, for example by physical deposition processes (such as sputtering) or chemical deposition processes (such as chemical vapour deposition or atomic layer deposition). Layers can be patterned by forming a mask, for example, using photolithography, electron-beam lithography or other appropriate lithographic process, etching using, for instance a reactive ion etch, or other suitable dry etch or wet etch, to remove unwanted regions of material and so form patterned layers.

It will be appreciated that many modifications may be made to the embodiments hereinbefore described.

Antiferromagnetic materials which exhibit a phase change between an antiferromagnetic and ferromagnetic phase other than FeRh can be used. For example, an antiferromagnetic material an alloy of Mn and antimony doped with a transition metal, i.e. Mn_{2-X}A_{X}Sb can be used, where A is a transition metal such as chromium (Cr), tin (Sn), cobalt (Co) or iron (Fe), where x is greater than o and less than 1.

In the examples hereinbefore described, the antiferromagnet consists of a material which exhibits a phase change between antiferromagnet and ferromagnetic phases. However, the antiferromagnet may be formed from iridium manganese (IrMn) or other antiferromagnetic materials which exhibit a transition between antiferromagnet and paramagnetic phases at the Néel temperature. Even though an external magnetic field is required to align magnetic moments in the paramagnetic phase, heat-assisted writing can still take advantage of the high-temperature paramagnetic phase to stabilise the antiferromagnetic phase.

As explained earlier, if an antiferromagnetic material does not exhibit bulk broken inversion symmetry, then inversion symmetry may be broken by making a layer of antiferromagnetic material sufficiently thin.

## Claims

1. An antiferromagnetic memory device (1) comprising:
an antiferromagnetic region (4) having a broken inversion symmetry that is, broken inversion symmetry in part of the unit cell corresponding to the antiferromagnetic spin sublattice or in the unit cell, and having an antiferromagnetic spin axis (6) which is selectively orientable along first and second easy axes (7₁, 7₂) which are not parallel to the axis along which inversion symmetry is broken; and
a conductive channel configured to define a conductive path (10₁) through the antiferromagnetic region which is substantially not parallel to the axis along which inversion symmetry is broken or a conductive path (50₁) through a paramagnetic or diamagnetic region (42) adjacent to the antiferromagnetic region so as to cause spin-polarised current to diffuse into the antiferromagnetic region having a component which is parallel to the axis along which inversion symmetry is broken.

2. An antiferromagnetic memory device according to claim 1, wherein the first and second easy axes (7₁, 7₂) are substantially perpendicular to each other.

3. An antiferromagnetic memory device according to claim 1 or 2, wherein the antiferromagnetic region (4) comprises an antiferromagnetic material which exhibits bulk broken inversion symmetry.

4. An antiferromagnetic memory device according to any preceding claim, wherein the antiferromagnetic region (4) is sufficiently thin along the axis so as to break structural inversion symmetry.

5. An antiferromagnetic memory device according to any preceding claim, wherein the conductive channel is a first conductive channel configured to define a first conductive path (10₁), wherein the memory device further comprises:
a second conductive channel configured to define a second conductive path (10₂) through the antiferromagnetic region (4) which is substantially not parallel to the axis (5) along which inversion symmetry is broken.

6. An antiferromagnetic memory device according to any one of claims 1 to 5, wherein the conductive channel comprises first and second conductive arms (8₁, 8₃) and the antiferromagnetic region (4), wherein the antiferromagnetic region is disposed between the first and second conductive arms such that current flow between the conductive arms through the antiferromagnetic region along the path (10₁).

7. An antiferromagnetic memory device according to claim 6, wherein the first and second conductive arms (8₁, 8₃) comprise a paramagnetic or diamagnetic material.

8. An antiferromagnetic memory device according to claim 6 or 7, wherein the first and second conductive arms (8₁, 8₃) comprise an antiferromagnetic material.

9. An antiferromagnetic memory device according to claim 8, wherein the conductive arms (8₁, 8₃) and the antiferromagnetic region (4) comprise the same antiferromagnetic material and wherein the conductive arms (8₁, 8₃) and/or antiferromagnetic region (4) are configured such that the antiferromagnetic region exhibits weaker magnetic anisotropy than the conductive arms.

10. An antiferromagnetic memory device according to any one of claims 1 to 5, wherein the conductive channel comprises a region (42) of paramagnetic or diamagnetic material which runs adjacent to the antiferromagnetic region (4) such that, in response to a current running along the conductive channel, a spin current diffuses into the antiferromagnetic region (4).

11. An antiferromagnetic memory device according to any preceding claim, further comprising:
first and second contacts to the antiferromagnetic region (4) for measuring ohmic resistance of the antiferromagnetic region.

12. An antiferromagnetic memory device according to any preceding claim, further comprising:
an electrode (23); and
a dielectric layer (22);
wherein the electrode (23), dielectric layer (22) and antiferromagnetic region (4) are arranged in a tunnel junction configuration (24).

13. Memory (52) comprising:
an array of memory cells (54), each memory cell including a memory device according to any one of claims 1 to 12.

14. A method of operating a memory device according to any one of claims 1 to 12 or memory according to claim 13, the method comprising:
driving a current along the conductive path (10₁; 50₁) having a sufficiently large current density that, in response to the antiferromagnetic spin (6) axis not being aligned perpendicularly to the current path (10₁), the current causes the antiferromagnetic spin axis to re-orientate perpendicularly to the current path (10₁; 50₁).

15. A method according to claim 14, further comprising:
driving a current along the conductive path (10₁; 50₁) or a conductive line proximate to the antiferromagnetic region (4) having a current profile to cause heating of the antiferromagnetic material so as to cause a transition in the antiferromagnetic region from an antiferromagnetic state to a ferromagnetic or paramagnetic state;
driving a current along the conductive path (10₁; 50₁) or a conductive line proximate to the antiferromagnetic region (4) to cause application of spin-transfer torque or an Oersted field such that when the current is removed and the antiferromagnetic region (4) returns to an antiferromagnetic state, the antiferromagnetic spin axis is orientated parallel or antiparallel to the current path (10₁; 50₁).

## Patentansprüche

1. Antiferromagnetisches Speichergerät (1), das Folgendes umfasst:
eine antiferromagnetische Region (4) mit einer unterbrochenen Umkehrsymmetrie, d.h. einer unterbrochenen Umkehrsymmetrie in einem Teil der Einheitszelle entsprechend dem antiferromagnetischen Spin-Untergitter oder in der Einheitszelle, und mit einer antiferromagnetischen Spin-Achse (6), die selektiv entlang einer ersten und zweiten leichten Achse (7₁, 7₂) orientiert werden kann, die nicht parallel zu der Achse sind, entlang der die Umkehrsymmetrie unterbrochen ist; und
einen leitfähigen Kanal, konfiguriert zum Definieren eines leitfähigen Pfades (10₁) durch die antiferromagnetische Region, die im Wesentlichen nicht parallel zu der Achse ist, entlang der die Umkehrsymmetrie unterbrochen ist, oder eines leitfähigen Pfades (50₁) durch eine paramagnetische oder diamagnetische Region (42) neben der antiferromagnetischen Region, um eine Diffusion von spin-polarisiertem Strom in die antiferromagnetische Region mit einer Komponente zu bewirken, die parallel zu der Achse ist, entlang der die Umkehrsymmetrie unterbrochen ist.

2. Antiferromagnetisches Speichergerät nach Anspruch 1, wobei die erste und die zweite leichte Achse (7₁, 7₂) im Wesentlichen lotrecht zueinander sind.

3. Antiferromagnetisches Speichergerät nach Anspruch 1 oder 2, wobei die antiferromagnetische Region (4) ein antiferromagnetisches Material umfasst, das masseunterbrochene Umkehrsymmetrie aufweist.

4. Antiferromagnetisches Speichergerät nach einem vorherigen Anspruch, wobei die antiferromagnetische Region (4) entlang der Achse ausreichend dünn ist, um strukturelle Umkehrsymmetrie zu unterbrechen.

5. Antiferromagnetisches Speichergerät nach einem vorherigen Anspruch, wobei der leitfähige Kanal ein erster leitfähiger Kanal ist, der zum Definieren eines ersten leitfähigen Pfades (10₁) konfiguriert ist, wobei das Speichergerät ferner Folgendes umfasst:
einen zweiten leitfähigen Kanal, konfiguriert zum Definieren eines zweiten leitfähigen Pfades (10₂) durch die antiferromagnetische Region (4), die im Wesentlichen nicht parallel zu der Achse (5) ist, entlang der die Umkehrsymmetrie unterbrochen ist.

6. Antiferromagnetisches Speichergerät nach einem der Ansprüche 1 bis 5, wobei der leitfähige Kanal einen ersten und einen zweiten leitfähigen Arm (8₁, 8₃) und die antiferromagnetische Region (4) umfasst, wobei die antiferromagnetische Region zwischen dem ersten und dem zweiten leitfähigen Arm angeordnet ist, so dass Strom zwischen den leitfähigen Armen durch die antiferromagnetische Region entlang dem Pfad (10₁) fließt.

7. Antiferromagnetisches Speichergerät nach Anspruch 6, wobei der erste und der zweite leitfähige Arm (8₁, 8₃) ein paramagnetisches oder diamagnetisches Material umfassen.

8. Antiferromagnetisches Speichergerät nach Anspruch 6 oder 7, wobei der erste und der zweite leitfähige Arm (8₁, 8₃) ein antiferromagnetisches Material umfassen.

9. Antiferromagnetisches Speichergerät nach Anspruch 8, wobei die leitfähigen Arme (8₁, 8₃) und die antiferromagnetische Region (4) dasselbe antiferromagnetische Material umfassen und wobei die leitfähigen Arme (8₁, 8₃) und/oder die antiferromagnetische Region (4) so konfiguriert sind, dass die antiferromagnetische Region eine schwächere magnetische Anisotropie aufweist als die leitfähigen Arme.

10. Antiferromagnetisches Speichergerät nach einem der Ansprüche 1 bis 5, wobei der leitfähige Kanal eine Region (42) aus paramagnetischem oder diamagnetischem Material umfasst, das neben der antiferromagnetischen Region (4) verläuft, so dass als Reaktion auf einen entlang dem leitfähigen Kanal laufenden Strom ein Spin-Strom in die antiferromagnetische Region (4) diffundiert.

11. Antiferromagnetisches Speichergerät nach einem vorherigen Anspruch, das ferner Folgendes umfasst:
erste und zweite Kontakte mit der antiferromagnetischen Region (4) zum Messen von ohmschem Widerstand der antiferromagnetischen Region.

12. Antiferromagnetisches Speichergerät nach einem vorherigen Anspruch, das ferner Folgendes umfasst:
eine Elektrode (23); und
eine dielektrische Schicht (22);
wobei die Elektrode (23), die dielektrische Schicht (22) und die antiferromagnetische Region (4) in einer Tunnelübergangskonfiguration (24) angeordnet sind.

13. Speicher (52), der Folgendes umfasst:
eine Anordnung von Speicherzellen (54), wobei jede Speicherzelle ein Speichergerät nach einem der Ansprüche 1 bis 12 umfasst.

14. Verfahren zum Betreiben eines Speichergeräts nach einem der Ansprüche 1 bis 12 oder Speicher nach Anspruch 13, wobei das Verfahren Folgendes beinhaltet:
Treiben eines Stroms entlang dem leitfähigen Pfad (10₁; 50₁) mit einer ausreichend großen Stromdichte, die als Reaktion darauf, dass die antiferromagnetische Spin-Achse (6) nicht lotrecht zu dem Strompfad (10₁) ausgerichtet ist, bewirkt, dass die antiferromagnetische Spin-Achse lotrecht zum Strompfad (10₁; 50₁) neu orientiert wird.

15. Verfahren nach Anspruch 14, das ferner Folgendes beinhaltet:
Treiben eines Stroms entlang dem leitfähigen Pfad (10₁; 50₁) oder einem Leiter in der Nähe der antiferromagnetischen Region (4) mit einem Stromprofil, das ein Erhitzen des antiferromagnetischen Materials bewirkt, um einen Übergang in der antiferromagnetischen Region von einem antiferromagnetischen Zustand in einen ferromagnetischen oder paramagnetischen Zustand zu bewirken;
Treiben eines Stroms entlang dem leitfähigen Pfad (10₁; 50₁) oder einem Leiter in der Nähe der antiferromagnetischen Region (4), um ein Aufbringen von Spin-Transfer-Drehmoment oder eines Oersted-Feldes zu bewirken, so dass die antiferromagnetische Spin-Achse, wenn der Strom weggenommen wird und die antiferromagnetische Region (4) in einen antiferromagnetischen Zustand zurückkehrt, parallel oder antiparallel zum Strompfad (10₁; 50₁) orientiert ist.

## Revendications

1. Dispositif de mémoire antiferromagnétique (1) comportant :
une région antiferromagnétique (4) ayant une symétrie d'inversion rompue à savoir, une symétrie d'inversion rompue dans une partie de la cellule élémentaire correspondant au sous-réseau de rotation antiferromagnétique ou dans la cellule élémentaire, et ayant un axe de rotation antiferromagnétique (6) qui est en mesure d'être orienté de manière sélective le long de premier et deuxième axes faciles (7₁, 7₂) qui ne sont pas parallèles par rapport à l'axe le long duquel la symétrie d'inversion est rompue ; et
un canal conducteur configuré pour définir un chemin conducteur (10₁) au travers de la région antiferromagnétique qui est sensiblement non parallèle par rapport à l'axe le long duquel la symétrie d'inversion est rompue ou un chemin conducteur (50₁) au travers d'une région paramagnétique ou diamagnétique (42) adjacente par rapport à la région antiferromagnétique de manière à amener un courant polarisé par rotation à se diffuser dans la région antiferromagnétique ayant un composant qui est parallèle par rapport à l'axe le long duquel la symétrie d'inversion est rompue.

2. Dispositif de mémoire antiferromagnétique selon la revendication 1, dans lequel les premier et deuxième axes faciles (7₁, 7₂) sont sensiblement perpendiculaires l'un par rapport à l'autre.

3. Dispositif de mémoire antiferromagnétique selon la revendication 1 ou la revendication 2, dans lequel la région antiferromagnétique (4) comporte un matériau antiferromagnétique qui présente une symétrie d'inversion rompue de masse.

4. Dispositif de mémoire antiferromagnétique selon l'une quelconque des revendications précédentes, dans lequel la région antiferromagnétique (4) est suffisamment mince le long de l'axe de manière à rompre la symétrie d'inversion de structure.

5. Dispositif de mémoire antiferromagnétique selon l'une quelconque des revendications précédentes, dans lequel le canal conducteur est un premier canal conducteur configuré pour définir un premier chemin conducteur (10₁), dans lequel le dispositif de mémoire comporte par ailleurs :
un deuxième canal conducteur configuré pour définir un deuxième chemin conducteur (10₂) au travers de la région antiferromagnétique (4) qui est sensiblement non parallèle par rapport à l'axe (5) le long duquel la symétrie d'inversion est rompue.

6. Dispositif de mémoire antiferromagnétique selon l'une quelconque des revendications 1 à 5, dans lequel le canal conducteur comporte des premier et deuxième bras conducteurs (8₁, 8₃) et la région antiferromagnétique (4), dans lequel la région antiferromagnétique est disposée entre les premier et deuxième bras conducteurs de telle sorte que le courant s'écoule entre les bras conducteurs au travers de la région antiferromagnétique le long du chemin (10₁).

7. Dispositif de mémoire antiferromagnétique selon la revendication 6, dans lequel les premier et deuxième bras conducteurs (8₁, 8₃) comportent un matériau paramagnétique ou diamagnétique.

8. Dispositif de mémoire antiferromagnétique selon la revendication 6 ou la revendication 7, dans lequel les premier et deuxième bras conducteurs (8₁, 8₃) comportent un matériau antiferromagnétique.

9. Dispositif de mémoire antiferromagnétique selon la revendication 8, dans lequel les bras conducteurs (8₁, 8₃) et la région antiferromagnétique (4) comportent le même matériau antiferromagnétique et dans lequel les bras conducteurs (8₁, 8₃) et/ou la région antiferromagnétique (4) sont configurés de telle sorte que la région antiferromagnétique présente une anisotropie magnétique plus faible par rapport aux bras conducteurs.

10. Dispositif de mémoire antiferromagnétique selon l'une quelconque des revendications 1 à 5, dans lequel le canal conducteur comporte une région (42) de matériau paramagnétique ou diamagnétique qui s'étend de manière adjacente par rapport à la région antiferromagnétique (4) de telle sorte que, en réponse à un courant circulant le long du canal conducteur, un courant de rotation se diffuse dans la région antiferromagnétique (4).

11. Dispositif de mémoire antiferromagnétique selon l'une quelconque des revendications précédentes, comportant par ailleurs :
des premier et deuxième contacts sur la région antiferromagnétique (4) pour mesurer la résistance ohmique de la région antiferromagnétique.

12. Dispositif de mémoire antiferromagnétique selon l'une quelconque des revendications précédentes, comportant par ailleurs :
une électrode (23) ; et
une couche diélectrique (22) ;
dans lequel l'électrode (23), la couche diélectrique (22) et la région antiferromagnétique (4) sont agencées en une configuration de jonction à effet de tunnel (24).

13. Mémoire (52) comportant :
un réseau de cellules de mémoire (54), chaque cellule de mémoire comprenant un dispositif de mémoire selon l'une quelconque des revendications 1 à 12.

14. Procédé d'exploitation d'un dispositif de mémoire selon l'une quelconque des revendications 1 à 12, ou mémoire selon la revendication 13, le procédé comportant :
l'étape consistant à entraîner un courant le long du chemin conducteur (10₁ ; 50₁) ayant une densité de courant suffisamment importante de telle sorte que, en réponse au non-alignement de l'axe de rotation antiferromagnétique (6) de manière perpendiculaire par rapport au chemin de courant (10₁), le courant amène l'axe de rotation antiferromagnétique à se réorienter de manière perpendiculaire par rapport au chemin de courant (10₁ ; 50₁).

15. Procédé selon la revendication 14, comportant par ailleurs les étapes consistant à :
entraîner un courant le long du chemin conducteur (10₁ ; 50₁) ou une ligne conductrice à proximité de la région antiferromagnétique (4) ayant un profil de courant pour amener le chauffage du matériau antiferromagnétique de manière à amener une transition dans la région antiferromagnétique pour passer d'un état antiferromagnétique à un état ferromagnétique ou paramagnétique ;
entraîner un courant le long du chemin conducteur (10₁ ; 50₁) ou une ligne conductrice à proximité de la région antiferromagnétique (4) pour amener l'application d'un couple de transfert de rotation ou d'un champ OErsted de telle sorte que, quand le courant est supprimé et quand la région antiferromagnétique (4) retourne à un état antiferromagnétique, l'axe de rotation antiferromagnétique est orienté de manière parallèle ou antiparallèle par rapport au chemin de courant (10₁ ; 50₁).
